# EUROPÄISCHE PATENTANMELDUNG

(11) **EP 4 686 100 A1**
(43) Veröffentlichungstag der Anmeldung: **28.01.2026**
(21) Anmeldenummer: 25187820.3
(22) Anmeldetag: 07.07.2025
(51) Int. Cl.: H03K 19/003, H03K 23/66, H03K 21/02

(54) **DIGITALER FREQUENZTEILER, SPANNUNGSVERSORGUNG UND EIN VERFAHREN ZUM BETREIBEN UND TESTEN EINER SPANNUNGSVERSORGUNG**

(30) Priorität: 26.07.2024 DE 102024121380
(71) Anmelder: KNORR-BREMSE Systeme für Nutzfahrzeuge GmbH, 80809 München (DE)
(72) Erfinder: RAMMERT, Alexander, 80997 München (DE); STEGMANN, Manuel, 70193 Stuttgart (DE); SCHOLL, Frank, 74379 Ingersheim (DE); MATT, Alexander, 76646 Bruchsal (DE); ROTH, Matthias, 71665 Vaihingen an der Enz (DE); HERRMANN, Günter, 70569 Stuttgart (DE); ATMACA, Emirhan, 74232 Abstatt (DE); KAUFMANN, Christian, 71063 Sindelfingen (DE); FUNK, Dominick Willi Hermann, 75239 Eisingen (DE)

(57) **Zusammenfassung**

Ein Digitaler Frequenzteiler (10) für eine Spannungsversorgungsschaltung (500) eines Controllers (600) ist offenbart. Der digitale Frequenzteiler (10) umfasst eine Zähleinheit (100), die einen Takteingang (110) für ein Taktsignal (50), einen Rücksetzeingang (120) für ein Rücksetzsignal und einer Vielzahl von Ausgängen (130) für Teilersignale (Qn) aufweist. Die Zähleinheit (100) ist ausgebildet, um die Teilersignale (Qn) als eine Teilung des Taktsignales (50) mit einer Potenz von 2 zu erzeugen. Der digitale Frequenzteiler (10) umfasst weiter eine erste Kopplungsschaltung (200) zum Koppeln der Teilersignale (Qn) zu einem Koppelsignal (250), wobei das Koppelsignal (250) ein logisches HIGH nur aufweist, wenn alle gekoppelten Teilersignale (Qn) ein logisches HIGH aufweisen; und eine zweite Kopplungsschaltung (300), die ausgebildet ist, um das Koppelsignal (250) in den Rücksetzeingang (120) der Zähleinheit (100) einzugeben.

## Beschreibung

Die vorliegende Erfindung bezieht sich auf einen digitalen Frequenzteiler, eine Spannungsversorgung für einen Controller und ein Verfahren zum Betreiben und Testen einer Spannungsversorgungsschaltung und insbesondere auf einen digitalen Frequenzteiler mit einstellbarem Teilerfaktor und Testmöglichkeiten.

Für die Spannungsversorgung eines Controllers (insbesondere für einen Microcontroller) werden häufig entsprechende Spannungsversorgungschips (SVC) verwendet. Zur Überwachung der Kompatibilität und der Einsatzfähigkeit beider Komponenten, werden Überwachungsschaltungen (sogenannte Watchdog-Schaltungen) genutzt. Eine Möglichkeit für die Überwachung ist das sogenannte Frequenzfensterverfahren, bei dem die Überwachungsschaltung eine vom Controller ausgesandte Frequenz überwacht, ob diese in einem Akzeptanzfenster liegt. Falls die ausgesandte Frequenz von dem Controller außerhalb des Akzeptanzfensters liegt, kann die Überwachungsschaltung ein Warnsignal ausgeben, um beispielsweise das System in einen sicheren Zustand zu versetzen und einen Nutzer über den Fehlerzustand zu informieren. Dies wird auch bei der vorliegenden Offenbarung zu genutzt.

Insbesondere im Fahrzeugbereich gibt es viele Controller für verschiedenste Funktionen, die mit unterschiedlichen Spannungsversorgungseinheiten kombiniert werden können. Typischerweise kommen die Komponenten von verschiedenen Herstellern. Hieraus ergibt sich die Gefahr von Kompatibilitätsproblemen, wenn beispielsweise ein Microcontroller und Spannungsversorgungschip verschaltet werden, die nicht miteinander kompatibel sind. Dies kann, wie oben beispielsweise beschrieben, über ein Akzeptanzfenster detektiert werden. Konventionelle Überwachungsschaltungen bieten allerdings wenig Flexibilität bei der Einstellung des Akzeptanzfensters. Das liegt insbesondere an den dafür eingesetzten internen Frequenzteilern.

Daher besteht ein Bedarf nach Frequenzteilern, die es erlauben, Akzeptanzfenster möglichst flexibel einstellen zu können.

Zumindest ein Teil der obengenannten Probleme wird durch einen digitalen Frequenzteiler nach Anspruch 1, eine Spannungsversorgungsschaltung nach Anspruch 7, einen Controller nach Anspruch 10 und ein Verfahren zum Betreiben und Testen einer Spannungsversorgungsschaltung nach Anspruch 13 überwunden. Die abhängigen Ansprüche beziehen sich auf weitere vorteilhafte Ausgestaltungen der Gegenstände der unabhängigen Ansprüche.

Die vorliegende Erfindung bezieht sich auf einen digitalen Frequenzteiler für eine Spannungsversorgungsschaltung eines Controllers. Der digitale Frequenzteiler umfasst eine Zähleinheit, die einen Takteingang für ein Taktsignal, einen Rücksetzeingang für ein Rücksetzsignal (reset signal) und eine Vielzahl von Ausgängen für Teilersignale. Die Zähleinheit ist ausgebildet, um die Teilersignale als eine Teilung des Taktsignales mit einer Potenz von 2 zu erzeugen. Dies wird im Rahmen der vorliegenden Offenbarung auch als binäres Teilerverhältnis bezeichnet. Der digitale Frequenzteiler umfasst außerdem eine erste Kopplungsschaltung und eine zweite Kopplungsschaltung. Die erste Kopplungsschaltung koppelt die Teilersignale derart zu einem Koppelsignal, dass das Koppelsignal ein logisches HIGH nur aufweist, wenn alle gekoppelten Teilersignale ein logisches HIGH aufweisen (ansonsten ist das Koppelsignal auf LOW; d.h. eine logische UND Verknüpfung). Die zweite Kopplungsschaltung ist ausgebildet, um das Koppelsignal zumindest in den Rücksetzeingang der Zähleinheit einzugeben.

Wenn die Frequenz des Taktsignal f0 ist, dann haben die Teilersignale eine Frequenz von f0/2', wobei i eine natürliche Zahl größer Null ist. Das Koppelsignal selbst ist auch wieder ein Taktsignal, welches durch Teilung des Taktsignals erhalten wird - allerdings mit einer beliebigen (ganzzahligen) Teilerfrequenz f = f0/n, und n = 3, 4, 5, 6, 7, .... Die Zähleinheit (Zähler oder Zählgerät) kann als ein digitaler Asynchronzähler oder asynchroner Dualzähler ausgebildet sein und umfasst beispielsweise zumindest eine T-Flipflop-Schaltung. Im Gegensatz zu konventionellen digitalen Frequenzteilern kann somit das Teilerverhältnis 1:n sein, wenn n≠ 2ⁱ für i eine natürliche Zahl größer Null. Im Rahmen der vorliegenden Offenbarung wird dies auch als nicht-binäres Teilerverhältnis bezeichnet, im Gegensatz zu binären Teilerverhältnissen, die eine Teilung einer 2er-Potenz sind. Ausführungsbeispiele erlauben daher auch ungerade Teilerfaktoren (z.B. 1/7 oder 1/5 oder 1/9).

Optional umfasst die erste Kopplungsschaltung für jedes Teilersignal einen (eigenen) Eingang mit jeweils einer Diode. Die Dioden sind derart angeordnet, um einen Signalfluss in die Zähleinheit hinein zu unterdrücken (und so eine Wechselwirkung der Ausgänge der Zählereinheit untereinander zu vermeiden) und um die Teilersignale von der Zähleinheit an einem Ausgang der ersten Kopplungsschaltung zu dem Koppelsignal zu überlagern. Beispielsweise kann die erste Kopplungsschaltung nur einen einzigen Ausgang aufweisen, der mit den Ausgängen der Dioden (stromabwärts des Signalflusses) verbunden ist. Mit anderen Worten, die entsprechenden Signalleitungen können am Ausgang elektrisch miteinander verbunden sein, sodass die Signale sich überlagern und das entsprechende Kopplungssignal gebildet wird. Optional wäre es auch möglich, dass die erste Kopplungsschaltung durch zumindest ein UND-Gatter mit einer Vielzahl von Eingängen gebildet wird. Es versteht sich, dass die einfache Realisierung mit Dioden gegenüber dem UND-Gatter den Vorteil bietet, dass die Schaltung durch einfache Mittel auf einer Leiterplatte realisiert werden kann. Ein UND-Gatter wäre eine deutlich komplexere Schaltung.

Optional umfasst die erste Kopplungsschaltung zumindest einen Schalter zwischen einer jeweiligen Diode und dem zugehörigen Eingang der ersten Kopplungsschaltung, um ansprechend auf ein Steuersignal (z.B. von einem Controller) die jeweilige Diode zu entkoppeln und so ein Kopplungssignal mit einem anderen Teilerverhältnis zu erzeugen. Die Ausgänge können auf diese Weise aktiviert/deaktiviert werden und das Teilerverhältnis wird dadurch geändert. Optional sind aber auch keine Schalter vorgesehen, um ein festes Teilerverhältnis zu implementieren. Weder die Schalter, noch die Dioden sind zwingend (stattdessen könnte auch ein UND-Gatter vorhanden sein).

Optional umfasst die zweite Kopplungsschaltung eine Verzögerungsschaltung, die ausgebildet ist, um das Koppelsignal von der ersten Kopplungsschaltung zeitlich verzögert in den Rücksetzeingang der Zähleinheit einzugeben. Auf diese Weise können Interferenzen vermieden werden, wenn z.B. ein Signaltakt noch nicht ordentlich abgeschlossen ist, die Zähleinheit aber durch ein HIGH am Rücksetzeingang bereits zurückgesetzt wird. Durch die Verzögerungsschaltung wird somit in dem Koppelsignal der HIGH-Pegel lange genug ausgebildet. Die Verzögerungsschaltung kann beispielsweise durch ein RC-Glied ausgebildet werden.

Optional umfasst die zweite Kopplungsschaltung einen Widerstand und einen Anschluss an eine Versorgungsspannung (die einen HIGH-Pegel liefert). Hierdurch wird der technische Effekt erreicht, dass der Zähler im Grundzustand zurückgesetzt ist (Reset), was durch den HIGH-Pegel erreicht wird.

Optional umfasst der digitale Frequenzteiler eine weitere Zähleinheit, die einen Takteingang für ein Taktsignal, einen Rücksetzeingang für ein Rücksetzsignal und eine Vielzahl von Ausgängen für weitere Teilersignale aufweist. Die zweite Kopplungsschaltung kann dann ausgebildet sein, um das Koppelsignal in den Takteingang der weiteren Zähleinheit einzugeben (d.h. es existiert eine entsprechende elektrische Verbindung). Der Rücksetzeingang der weiteren Zähleinheit kann mit einem Masseanschluss, GND, verbunden sein. Die Vielzahl von Ausgängen der weiteren Zähleinheit können als Ausgabesignale für die Spannungsversorgungsschaltung und/oder für den Controller bereitgestellt werden. Dies bietet ein Vorteil, dass auch der Controller eine Rückmeldung über die aktueller Frequenzteilung erhalten kann (z.B. für einen Testmodus). Die Ausgabesignale können somit für verschiedene Zwecke genutzt werden.

Ausführungsbeispiele beziehen sich auch auf eine Spannungsversorgungsschaltung für einen Controller eines Fahrzeuges. Die Spannungsversorgungsschaltung umfasst ein Power-Management-System zur Bereitstellung einer Spannung für den Controller und einen zuvor beschriebenen digitalen Frequenzteiler. Der digitale Frequenzteiler ist ausgebildet, um ein Taktsignal von dem Controller zu empfangen und das empfangene Taktsignal in einem vorbestimmten Teilerverhältnis zu teilen und eine Ausgabe (Ausgabesignal) an das Power-Management-System zu liefern (übertragen).

Das Fahrzeug kann ein Nutzfahrzeug (z.B. ein Lastkraftwagen oder ein Bus) sein. Das Power-management-System kann ein hochintegrierter Power-Management-IC (PMICs; IC= integrated circuit, engl.) sein. Das Power-management-System kann das Laden von Batterien, eine Spannungswandlung (z.B. AC/DC oder DC/DC), Analog-Digital-Wandlung (ADC), die Spannungsskalierung und andere Funktionen wie Überwachung, Sequenzierung und funktionale Sicherheitsunterstützung bereitstellen.

Optional ist das Power-Management-System ausgebildet, um den Controller basierend auf der Ausgabe bzw. das Ausgabesignal zu authentifizieren. Es kann beispielsweise geprüft werden, ob eine Frequenz der Ausgabe in einem vorbestimmten Akzeptanzfensters liegt. Somit kann der digitale Frequenzteiler Teil einer Überwachungsschaltung sein (z.B. ein sogenannter Watch-Dog), die sicherstellt, dass der Controller und die Spannungsversorgung zueinander kompatibel sind bzw. der Controller korrekt konfiguriert wurde. Erst dann kann der Controller mit der Spannungsversorgung verbunden werden. Somit ist es möglich, dass die Spannungsversorgung bzw. der entsprechende Chip und der Controller von verschiedenen Herstellern stammen können, ohne dass dadurch die Funktionsweise des gesamten Systems beeinträchtigt wird.

Optional umfasst das Taktsignal eine Frequenz f0 zwischen 10 KHz und 50 KHz oder von ungefähr 25 oder 28 KHz. Das vorbestimmte Teilerverhältnis kann 1:n betragen, wobei n eine ganze Zahl zwischen 6 und 32 oder mehr sein kann. Die Erfindung soll nicht auf bestimmte Werte eingeschränkt werden. Die konkreten Werte dienen nur als Beispielswerte. Wenn der digitale Frequenzteiler z. B. zwei Zähleinheiten aufweist, kann eine beispielhafte Frequenzteilung von 1:28 (28=7x4) umgesetzt werden. Bei einer beispielhaften Taktfrequenz von 25kHz kann ein Akzeptanzfenster von 0,75 ... 1 kHz gewählt werden, worin immer noch Toleranzschwankungen enthalten sind. Wenn kein erwartetes Signal in diesem beispielhaften Akzeptanzfenster empfangen wird, kann eine Warnung oder Fehlermeldung ausgegeben werden, die das System in einen sicheren Zustand versetzt.

Ausführungsbeispiele beziehen sich auch auf einen Controller eines Fahrzeugs, der Folgendes aufweist: einen Anschluss für eine zuvor beschriebene Spannungsversorgungschaltung und eine Ausgabe für ein Taktsignal mit vorbestimmter Frequenz f0 für einen zuvor beschriebenen digitalen Frequenzteiler. Der Controller ist ausgebildet, um den digitalen Frequenzteiler zu steuern.

Optional umfasst der Controller einen Controllereingang für eine Ausgabe des digitalen Frequenzteilers und optional zumindest einen Steuerausgang zum Ansteuern des zumindest einen Schalters, wie er als Teil des Frequenzteilers beschrieben wurde. Der Controller kann dann ausgebildet sein, um einen Testmodus auszulösen, in dem der Controller zumindest eines aus dem Folgenden bewirkt:
- Ändern der vorbestimmten Frequenz f0 des Taktsignals und Verifikation einer erwarteten Änderung am Controllereingang;
- wahlweises Entkoppeln einer oder mehrerer Dioden durch ein Betätigen der entsprechenden Schalter (abzuschalten zumindest einer Diode) und Verifikation einer erwarteten Änderung am Controllereingang.

Beispielsweise kann der Controller über einen Ausgang der weiteren Zähleinheit ein vorbestimmtes Frequenzsignal (=Signal mit vorbestimmter Frequenz) empfangen und mit einem Referenzwert vergleichen. Dadurch kann eine Überwachung (Monitoring) hinsichtlich einer korrekten Arbeitsweise implementiert werden. So kann der Controller die Schalter in der ersten Kopplungsschaltung des digitalen Frequenzteilers schalten, um gezielt ein Frequenzverhältnis zu ändern und in Antwort auf das empfangene Frequenzsignal bestimmen, ob die Spannungsversorgung erwartungsgemäß funktioniert (d.h. entsprechend der geänderten Frequenzteilung).

Ausführungsbeispiele beziehen sich auch auf ein Nutzfahrzeug (z.B. ein Lastkraftwagen oder ein Bus) mit einem zuvor beschriebenen Controller und einer zuvor beschriebenen Spannungsversorgungsschaltung.

Ausführungsbeispiele beziehen sich auch auf ein Verfahren zum Betreiben und Testen einer Spannungsversorgungsschaltung mit folgenden Schritten:
- Bereitstellen einer Spannung für einen Fahrzeugcontroller;
- Übermitteln, durch den Fahrzeugcontroller, eines Taktsignals mit einer vorbestimmten Frequenz f0;
- Teilen der Frequenz f0 des Taktsignal mit einem nicht-binären Teilerverhältnis; und
- Authentifizieren des Fahrzeugcontrollers, wenn die geteilte Frequenz in einem vorbestimmten Akzeptanzfenster liegt.

Wie bereits erwähnt ist im Rahmen der vorliegenden Offenbarung ein nicht-binäres Teilerverhältnis ein Teilerverhältnis 1:n für jedes n, das keine Potenz von 2 ist.

Optional umfasst das Verfahren ein Weiterleiten eines geteilten Frequenzsignals an einen Controllereingang des Fahrzeugcontrollers. Das Verfahren kann weiter ein Testen der Spannungsversorgung umfassen, wobei das Testen zumindest einen der folgenden Schritte umfasst:
- Ändern der vorbestimmten Frequenz des Taktsignals und Verifizieren einer erwarteten Änderung an dem Controllereingang;
- Ändern des nicht-binären Teilerverhältnisses und Verifizieren einer erwarteten Änderung an dem Controllereingang.

Wie bereits dargelegt kann durch wahlweises Entkoppeln einer oder mehrerer Dioden durch ein Betätigen der entsprechenden Schalter das Frequenzverhältnis geändert werden. Da diese Änderung bekannt ist, kann sie zum Testen genutzt werden.

Es versteht sich, dass alle zuvor beschriebenen Funktionen des Frequenzteilers als weitere optionale Verfahrensschritte ausgebildet sein können. Außerdem versteht es sich, dass die Reihenfolge der Nennung nicht notwendigerweise eine Reihenfolge bei der Ausführung der Verfahrensschritte ist. Die Schritte können auch in einer anderen Reihenfolge ausgeführt werden bzw. es wird nur ein Teil der Verfahrensschritte ausgeführt.

Dieses Verfahren oder zumindest Teile davon kann/können ebenfalls in Form von Anweisungen in Software oder auf einem Computerprogrammprodukt implementiert oder gespeichert sein, wobei gespeicherte Anweisungen in der Lage sind, die Schritte nach dem Verfahren auszuführen, wenn das Verfahren auf einem Prozessor läuft. Daher bezieht sich die vorliegende Erfindung ebenfalls auf Computerprogrammprodukt mit darauf gespeichertem Software-Code (Softwareanweisungen), der ausgebildet ist, um eines der zuvor beschriebenen Verfahren auszuführen, wenn der Software-Code durch eine Verarbeitungseinheit ausgeführt wird. Die Verarbeitungseinheit kann jede Form von Computer oder Steuereinheit sein, die einen entsprechenden Mikroprozessor aufweist, der einen Software-Code ausführen kann. Außerdem beziehen sich Ausführungsbeispiele auf ein computerlesbares Speichermedium mit darauf gespeicherten Anweisungen, die ausgebildet sind, um die zuvor beschriebene Spannungsversorgungschaltung und den zuvor beschriebenen Controller zu veranlassen, das Verfahren auszuführen, wenn die Anweisungen auf einer Datenverarbeitungseinheit ausgeführt werden.

Ausführungsbeispiele bieten den Vorteil, dass eine Unverträglichkeit zwischen dem Microcontroller und der Spannungsversorgung sofort feststellbar ist, da die von dem Microcontroller bereitgestellte Frequenz höchstwahrscheinlich außerhalb des Akzeptanzfensters liegt, welches gemäß Ausführungsbeispielen über einen großen Bereich frei einstellbar ist. Ein Nachteil von konventionellen Überwachungseinheiten besteht nämlich darin, dass das Akzeptanzfenster nur eingeschränkt bzw. hinsichtlich bestimmter zweier Potenzen der eingegebenen Taktfrequenz wählbar ist. Gemäß Ausführungsbeispielen können jedoch beliebige ungerade Teilerfaktoren realisiert werden, die deutlich mehr Möglichkeiten bereitstellen, um ein hinreichend enges Akzeptanzfenster bereitzustellen. So kann beispielsweise das Akzeptanzfenster zwischen 0,75 KHz und 1 KHz liegen, wenn die typische Taktfrequenz bei 25 oder 28 KHz liegt. Außerdem weisen Ausführungsbeispiele den Vorteil auf, dass Testmöglichkeiten vorgesehen sind. So kann beispielsweise der Teilerfaktor dynamisch über das Zu- und Abschalten von Dioden über vorgesehene Schalter geändert werden, wobei aus der Änderung genau abgelesen werden kann, ob die Überwachungseinheit bzw. die Spannungsversorgung wie vorgesehen arbeitet. Außerdem können über mehrere Ausgänge verschiedene Teilerfaktoren des eingegebenen Taktsignals realisiert werden, wobei es sich dabei nicht nur um Potenzen von zwei handelt, sondern ebenfalls ungerade Teilerfaktoren umsetzbar sind.

Aus der bewussten Verstimmung der Überwachungseinheit kann sehr schnell und zuverlässig getestet werden, ob der Frequenzteiler bzw. die Spannungsversorgung wie vorgesehen arbeiten.

Die Ausführungsbeispiele der vorliegenden Erfindung werden besser verstanden von der folgenden detaillierten Beschreibung und den beiliegenden Zeichnungen der unterschiedlichen Ausführungsbeispiele, die jedoch nicht so verstanden werden sollten, dass sie die Offenbarung auf die spezifischen Ausführungsformen einschränken, sondern lediglich der Erklärung und dem Verständnis dienen.
- Fig. 1: zeigt einen digitalen Frequenzteiler gemäß einem Ausführungsbeispiel der vorliegenden Erfindung.
- Fig. 2: zeigt weitere Details des Frequenzteiler gemäß weiterer Ausführungsbeispiele.
- Fig. 3: veranschaulicht die Frequenzteilung eines Frequenzteilers gemäß weiterer Ausführungsbeispiele.
- Fig. 4: veranschaulicht eine Implementierung einer Überwachungsschaltung in einer Spannungsversorgung für einen Controller gemäß Ausführungsbeispiele.
- Fig. 5: zeigt ein schematisches Flussdiagramm für ein Ausführungsbeispiel eines Verfahrens zum Betreiben einer Überwachungsschaltung.

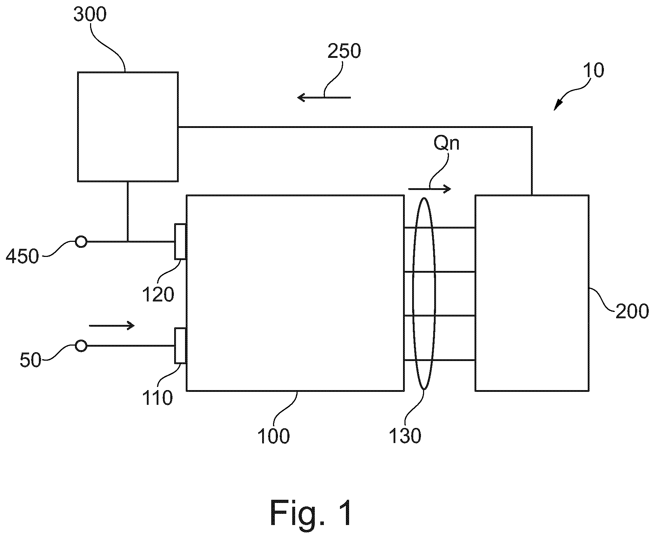

**Fig. 1** zeigt ein Ausführungsbeispiel für einen digitalen Frequenzteiler 10. Der digitale Frequenzteiler 10 kann beispielsweise in einer Spannungsversorgung integriert werden, die einen dazugehörigen Controller (z.B. in einem Fahrzeug) mit Strom versorgt. Der digitaler Frequenzteiler 10 kann aber auch als selbständige Komponente gebildet sein.

Der digitale Frequenzteiler 10 umfasst eine Zähleinheit 100. Die Zähleinheit 100 umfasst einen Takteingang 110 für ein Taktsignal 50, ein Rücksetzeingang 120 für ein Rücksetzsignal und eine Vielzahl von Ausgängen 130 für Teilersignale Qn (n = 1, 2, 3, 4, ...). Die Zähleinheit 100 ist ausgebildet, um die Teilersignale Qn als eine Teilung des Taktsignales 50 zu erzeugen, wobei die Teilung eine Potenz von zwei ist. So kann beispielsweise ein n-tes Teilersignal eine Teilerfrequenz von f = f0/2ⁿ aufweisen, wobei die f0 die Frequenz des Taktsignals 50 ist und n kann jede natürliche Zahl sein.

Der digitale Frequenzteiler 10 umfasst weiterhin eine erste Kopplungsschaltung 200 und eine zweite Kopplungsschaltung 300. Die erste Kopplungsschaltung 200 ist ausgebildet, um die Teilersignale Qn zu einem Koppelsignal 250 zu koppeln. Die Kopplung erfolgt derart, dass das Koppelsignal 250 ein logisches HIGH (HIGH-Pegel) nur dann aufweist, wenn alle gekoppelten Teilersignale Qn ein logisches HIGH aufweisen. Das Pegelniveau der HIGH Signale kann, muss sich aber nicht unterscheiden. Ansonsten ist das Koppelsignal 250 auf ein logisches LOW. Mit anderen Worten, wenn zumindest eines der Teilersignale Qn ein LOW aufweist, ist das Koppelsignal 250 ebenfalls ein LOW-Signal. Die erste Kopplungsschaltung 200 kann beispielsweise als ein UND-Gatter ausgebildet werden. Die zweite Kopplungsschaltung 300 koppelt das Koppelsignal 250 an dem Rücksetzeingang 120 der Zähleinheit 100. Im einfachsten Fall kann das Koppelsignal 250 einfach durchgeleitet werden.

Die Zähleinheit 100 kann beispielsweise ein digitaler Asynchronzähler bzw. ein asynchroner n-bit Dualzähler sein, der mehrere Ausgangssignale Qn aufweist, wobei jedes Ausgangssignal selbst ein Taktsignal ist, aber einer mit einer um eine 2er Potenz verringerten Frequenz.

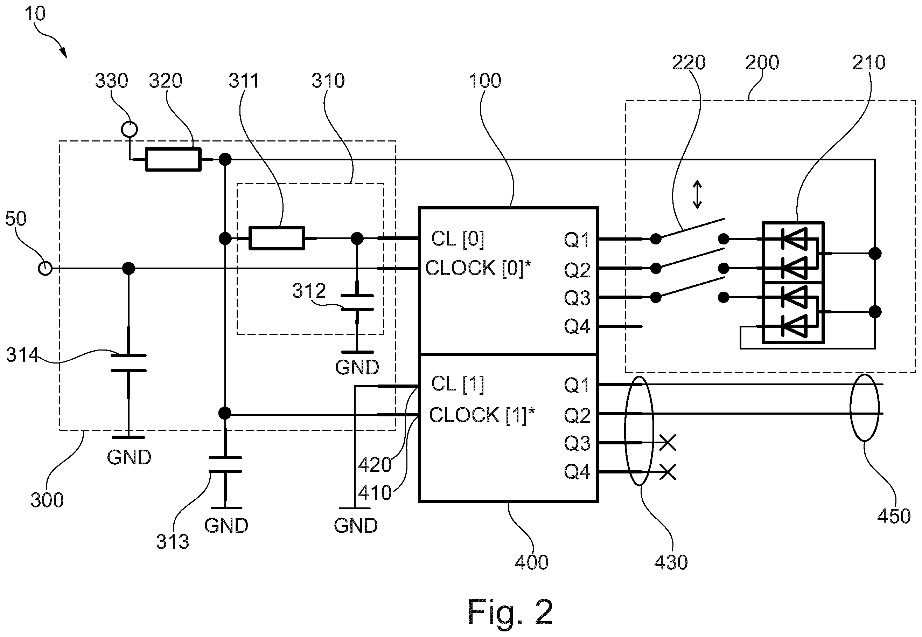

**Fig. 2** zeigt den digitalen Frequenzteiler, mit weiteren optionalen Details, die gemäß weiteren Ausführungsbeispielen ausgebildet sein können.

So umfasst die erste Kopplungsschaltung 200 für jedes Teilersignal Qn einen Eingang und jeweils einer Diode 210. Die Dioden 210 sind verschaltet bzw. ausgebildet, um eine Signalfluss in die Zähleinheit 100 zu unterdrücken und die Teilersignale Qn an einem Ausgang der ersten Kopplungsschaltung 200 zu dem Koppelsignal 250 zu überlagern. Sie entsprechenden Signalleitungen von den Dioden 210 können einfach miteinander elektrisch verbunden werden.

Gemäß dem gezeigten Ausführungsbeispiel kann die erste Kopplungsschaltung 200 zumindest einen Schalter 220 zwischen einer jeweiligen Diode 210 und dem jeweiligen Eingang der ersten Kopplungsschaltung 200 aufweisen. Alternativ könnte der/die Schalter 220 auch hinter der jeweiligen Diode 210 entlang des Signalflusses angeordnet sein/werden. In jedem Fall bewirkt der oder die Schalter 220, dass Signale durch die jeweilige Diode(n) 210 von dem Kopplungssignal 250 entkoppelt werden. Das wiederum hat zur Folge, dass ein anderes Teilerverhältnis erzeugt wird. Insbesondere kann aber auch für jede Diode 210 ein zugehöriger Schalter 220 vorgesehen sein. Der eine oder die mehreren Schalter 220 können einzeln angesteuert werden (z.B. durch den Controller oder eine andere Steuereinheit), um die Schaltung zu testen bzw. den Teilerfaktor (Teilerverhältnis) flexibel einstellen zu können.

Gemäß dem gezeigten Ausführungsbeispiel kann die zweite Kopplungsschaltung 300 eine Verzögerungsschaltung 310 aufweisen. Die Verzögerungsschaltung 310 ist ausgebildet ist, um das Koppelsignal 250 von der ersten Kopplungsschaltung 200 zeitlich verzögert in den Rücksetzeingang 120 der Zähleinheit 100 einzugeben. Beispielsweise kann die Verzögerungsschaltung 310 ein RC-Glied aufweisen, wobei das Koppelsignal 250 durch einen ersten Widerstand 311 geleitet wird und die Leitung zwischen dem ersten Widerstand 311 und dem Rücksetzeingang 120 über einen Kondensator 312 mit Masse GND verbunden ist.

Gemäß dem gezeigten Ausführungsbeispiel kann die zweite Kopplungsschaltung 300 einen zweiten Widerstand 320 und einen Anschluss 330 für eine Versorgungsspannung aufweisen. Damit wird sichergestellt, dass im Grundzustand die Zähleinheit 100 zurückgesetzt ist (Reset-Zustand), sodass nur wenn das Koppelsignal 250 einen LOW-Zustand liefert, die Zähleinheit 100 zu zählen beginnt.

Gemäß dem gezeigten Ausführungsbeispiel kann der digitaler Frequenzteiler 10 eine weitere Zähleinheit 400 aufweisen. Die weitere Zähleinheit 400 umfasst einen Takteingang 410 für ein Taktsignal, einen Rücksetzeingang 420 für ein Rücksetzsignal und eine Vielzahl von Ausgängen 430 für weitere Teilersignale. Sie kann beispielsweise baugleich zur Zähleinheit 100 sein, die weitere Zähleinheit 400 kann aber anders verschaltet werden. So ist gemäß dem gezeigten Ausführungsbeispiel die zweite Kopplungsschaltung 300 mit dem Takteingang 410 der weiteren Zähleinheit 400 verbunden, um das Koppelsignal 250 als Taktsignal für die zweite Zähleinheit 400 zu nutzen. Außerdem kann der Rücksetzeingang 420 der weiteren Zähleinheit 400 mit einem Masseanschluss GND verbunden sein. Die Ausgänge 430 der weiteren Zähleinheit 400 sind nutzbar, um verschiedene Teilerfrequenzen als Ausgabesignale 450 für andere Komponenten bereitzustellen (z.B. für die Spannungsversorgung und/oder dem Controller). Zwei der Ausgänge 430 sind in dem gezeigten Ausführungsbeispiel ungenutzt (die unteren beiden), können aber optional ebenfalls als Ausgabe 450 genutzt werden, um andere Teilerverhältnisse zu realisieren. Beispielsweise kann der Controller gezielt Signale von einem der Ausgänge 450 abfragen, um den Frequenzteiler 10 zu testen (z.B. durch Vergleich mit einer zu erwartenden Frequenz).

Gemäß dem gezeigten Ausführungsbeispiel kann der digitale Frequenzteiler 10 Filtereinheiten aufweisen, um beispielsweise hochfrequente Störsignale herauszufiltern. Beispielsweise kann ein zweite Kondensator 313 als ein Tiefpassfilter für das Koppelsignal 250 ausgebildet werden, d.h. hochfrequente Signalkomponenten des Koppelsignals 250 werden nach Masse GND abgeleitet. Ein weiterer Tiefpassfilter kann optional an einem Eingang für das Taktsignal 50 als ein vierter Kondensator 314 ausgebildet werden.

Gemäß Ausführungsbeispielen kann das Taktsignal 50 einen Wert zwischen 10 KHz und 100 KHz oder ungefähr 25 KHz oder ungefähr 28 kHz aufweisen. Außerdem kann an ein Ausgabesignal 450 eine Frequenz f im Vergleich zum Taktsignal 50 ein Teilerverhältnis von 1:28 oder 1:56 aufweisen (d.h. f = f0/28, f0/56). Bei 25 kHz Taktfrequenz ergibt sich somit eine Frequenz von ca. 0,9 kHz oder ca. 450 Hz. Das Akzeptanzfenster für die Überwachungsschaltung kann somit für den Frequenzbereich zwischen 0,75 ... 1 kHz gewählt werden. Es versteht sich, dass die Werte lediglich beispielhaft sind, Ausführungsbeispiele sollen nicht auf diese konkreten Werte eingeschränkt werden.

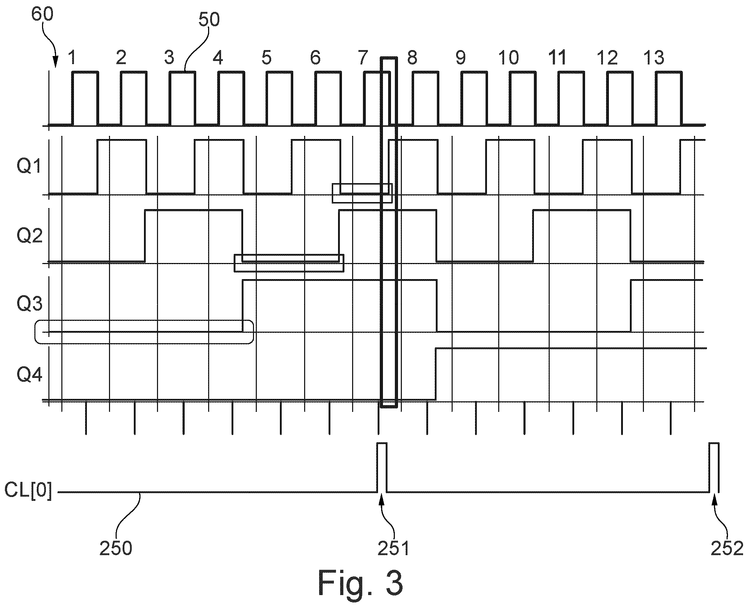

**Fig. 3** veranschaulicht die Arbeitsweise des digitalen Frequenzzählers 10 aus Fig. 2. Zunächst ist in der Fig. 3 oben das Taktsignal 50 mit einer vorbestimmten Frequenz f0 dargestellt. Außerdem ist darunter das erste Teilersignal Q1 dargestellt. Auch das erste Teilersignal Q1 ist ein Taktsignal, jedoch mit nur der halben Taktfrequenz f0/2 im Vergleich zum Taktsignal 50. Ferner ist darunter das zweite Teilersignal Q2 dargestellt, welches auch ein Taktsignal mit einer Taktfrequenz von ¼ der Frequenz f0 des Taktsignals 50 ist. Außerdem ist darunter das dritte Teilersignal Q3 dargestellt, welches eine Taktfrequenz von 1/8 der Frequenz des Taktsignals 50 aufweist. Somit sind die Teilerfrequenzen der Teilersignale Q1, Q2 und Q3 um den Faktor 1/2' (i=1,2,3) verringert (bezüglich des Taktsignales 50). Optional kann ebenfalls ein viertes Teilersignal Q4 vorgesehen sein, welches eine Taktfrequenz von 1/16 im Vergleich zu dem Taktsignal 50 aufweist. Diese Teilersignal Q1, Q2, Q3, Q4 werden von der Zähleinheit 100 ausgegeben.

Am Anfang ist der Grundzustand 60 dargestellt, der z.B. anliegt, wenn kein Taktsignal 50 eingegeben wird. In dem Grundzustand 60 liegen alle Ausgänge auf ein LOW-Pegel und die Zustand wird durch den Anschluss and die Stromversorgung über den Anschluss 330 sichergestellt.

Ganz unten in der Fig. 3 ist das resultierende Koppelsignal 250 dargestellt. Gemäß Ausführungsbeispielen erfolgt das Koppeln derart, dass das Koppelsignal 250 grundsätzlich auf LOW liegt, solange zumindest eines der drei Teilersignale Q1, Q2 oder Q3 auf LOW liegt. Ausführungsbeispiele erreichen dies dadurch, dass die Ausgänge der Dioden 210 stromabwärts vom Signalflusses elektrisch miteinander verbunden sind. Das Koppelsignal 250 springt somit nur auf ein logisches HIGH 251, 252, wenn alle auf HIGH-Pegel liegen, d.h., wenn der siebte Takt des Taktsignals 50 endet.

Da das Koppelsignal 250 auf den Rücksetzeingang 120 der Zählereinheit 100 zurückgeführt wird, wird in diesem Moment die Zähleinheit 100 zurückgesetzt. Damit wird die Zähleinheit 100 in den Grundzustand 60 versetzt, der vor dem ersten Takt des Taktsignals 50 angelegen hat. Dann wiederholt sich die Prozedur, sodass ebenfalls erst wieder mit dem Ende des 7. Taktes das Koppelsignal 250 den Zustand HIGH aufweist (siehe Pulse 251 und 252).

Aus dem gezeigten Koppeln der Teilersignale Q1, Q2, Q3 ergibt sich, dass das Koppelsignal 250 eine Teilerfrequenz von 1/7*f0 aufweist, das heißt 7 Takte werden zunächst abgewartet, bevor das Koppelsignal 250 das erste HIGH-Signal aufweist. Bis dahin war das Koppelsignal 250 konstant auf LOW.

Es versteht sich, dass, wenn einzelne Dioden 210 der ersten Kopplungsschaltung 200 abgeschaltet werden, die entsprechenden Teilersignale Q1 oder Q2 oder Q3 nicht vorhanden sind. So führt beispielsweise die Abwesenheit des Teilersignals Q2 dazu, dass das Koppelsignal 250 den ersten HIGH-Zustand nach dem fünften Takt einnimmt, d.h. das Teilerverhältnis ist 1/5. Durch das Abschalten der ersten Diode 210 und dementsprechend des ersten Teilersignals Q1 wird erreicht, dass das erste HIGH-Signal im Koppelsignal 250 nach 6 Takten erreicht wird (Teilerfrequenz wäre 1/6*f0). Schließlich wird durch ein Abschalten der dritten Diode und somit des dritten Teilersignals Q3 erreicht, dass das erste HIGH-Signal in dem Koppelsignal 250 nach drei Takten erreicht wird (Teilerfrequenz wäre 1/3*f0). Somit können viele Teilerverhältnis durch An- und Abschalten der entsprechenden Dioden bzw. der entsprechenden Teilersignale Q1, Q2, Q3 erreicht werden. Durch den optionalen Anschluss des vierten Teilersignals Q4 können weitere Teilerfaktoren realisiert werden (z.B. von 1/2 bis 1/15).

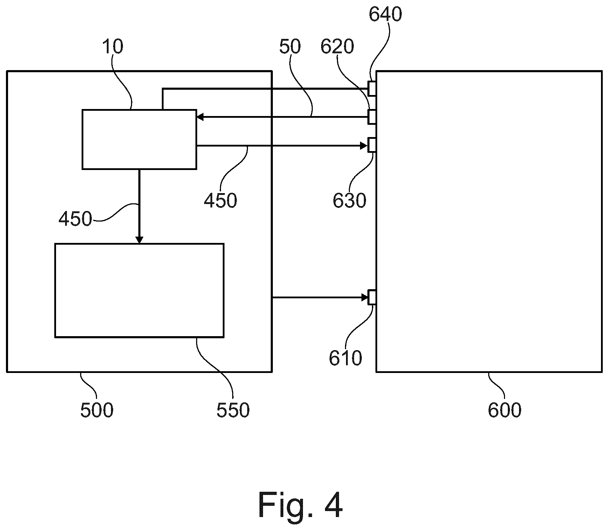

**Fig. 4** zeigt ein Ausführungsbeispiel für eine Spannungsversorgungsschaltung 500 für einen Controller 600, wobei die Spannungsversorgungsschaltung 500 einen zuvor beschriebenen digitalen Frequenzteiler 10 aufweist, der für eine Überwachungsschaltung (Watchdog-Schaltung) genutzt wird oder ein Teil davon ist. Die Überwachungsschaltung kann sicherstellen, dass der Controller 600 wie erwartet funktioniert. Der Controller 600 kann ein beliebiger Fahrzeugcontroller sein, der eine vorbestimmte Funktion im Fahrzeug (z.B. in einem Lastkraftwagen) bereitstellt. Die vorbestimmten Funktionen können z.B. die Lenkung, die Bremsung, die Gangschaltung und anderes mehr sein. Insbesondere kann der Controller 600 ein Mikrocontroller sein.

Außerdem kann die Spannungsversorgungsschaltung 500 ein Power-Management-System 550 aufweisen, welches z.B. einen Spannungsversorgungschip umfassen kann. Das Power-Management-System 550 kann beispielsweise ein hochintegrierter Power-Management-Schaltung (PMICs) sein, die z.B. ein Laden von Batterien, eine Spannungswandlung (Wechselspannung zu Gleichspannung, DC, oder DC/DC), eine analog-digital-Wandlung (ADC), eine Spannungsskalierung, eine Überwachung, Sequenzierung und andere funktionale Sicherheitsunterstützung bereitstellen kann. Die Spannungsversorgungsschaltung 500 dient somit zumindest der Spannungsversorgung für den Controller 600, der hierzu einen Versorgungsanschluss 610 aufweist.

Gemäß Ausführungsbeispielen übermittelt der Controller 600 ein Frequenzsignal (z.B. das Taktsignal 50) über den Ausgabe 620 (Taktsignalausgang) an den digitalen Frequenzteiler 10. Der Frequenzteiler 10 wird auf eine vorbestimmte Teilerfrequenz 1:n eingestellt und die Ausgabe 450 hat eine Frequenz f = f0/n, wobei n eine beliebige natürliche Zahl sein kann. Insbesondere ist n eine nicht-binäre Zahl (d.h. keine Potenz von 2), kann aber gemäß Ausführungsbeispiele frei gewählt werden.

Gemäß Ausführungsbeispielen überprüft die Überwachungsschaltung, ob die Frequenz f des Ausgabesignals 450 in einem Akzeptanzfenster (= Frequenzbereich vorbestimmter Größe) liegt. Wenn das der Fall ist, kann die Spannungsversorgungsschaltung 500 den Controller 600 entsprechend authentifizieren. Falls dies nicht der Fall ist, kann eine entsprechende Warnung ausgegeben werden bzw. die Spannungsversorgungsschaltung 500 kann die Spannungsversorgung unterbrechen, da der entsprechende Controller 600 nicht kompatibel zu sein scheint.

Gemäß Ausführungsbeispielen kann der Controller 600 den Frequenzteiler 10 bzw. die Spannungsversorgungsschaltung 500 testen. Hierfür kann die Controller 600 eine Verbindung über einen Signaleingang 630 (Controllereingang) mit einer Ausgabe 450 des digitalen Frequenzteilers 10 aufweisen, um zumindest ein Ausgabesignal 450 zu empfangen. Beim Testen (Testmodus) kann der Controller 600 die Taktfrequenz f0 des Taktsignales 50 über den Taktsignalausgang 620 verstimmen, z.B. anstatt 25 kHz nur 15 KHz oder 30 kHz ausgeben. Wenn das Teilerverhältnis beim Testen gleichbleibt, wird die Frequenz f des empfangenen Ausgabesignales 450 sich ändern. Aus der Änderung kann der Controller 600 schließen, ob der Frequenzteiler 10 wie erwartet operiert.

Außerdem kann der Controller 600 über einen entsprechende Steuerausgang 640 Steuerleitungen ansteuern, die mit einen oder mit mehreren oder mit allen Schaltern 220 der ersten Kopplungsschaltung 200 verbunden sind, um gezielt das Teilerverhältnis des Frequenzteilers 10 zu ändern. Auch hierbei wird es zu einer erwarteten Änderung der Frequenz f im Ausgabesignal 450 kommen und die Controller 600 kann daraus schließen, ob der Frequenzteiler 10 bzw. die Überwachungsschaltung wie gewünscht funktionieren. Ausführungsbeispiele ermöglichen somit ein Monitoring des Frequenzteilers 10 durch den Controller 600.

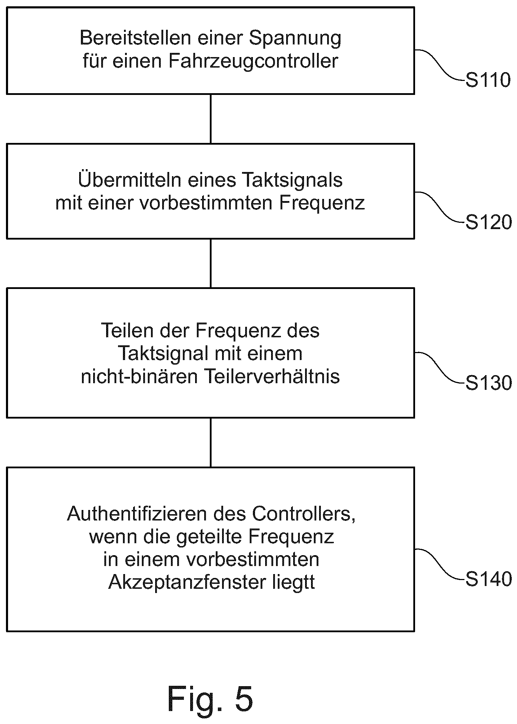

**Fig. 5** zeigt ein schematisches Flussdiagramm für ein Ausführungsbeispiel eines Verfahrens zum Betreiben einer Überwachungsschaltung, die beispielsweise in der Spannungsversorgungsschaltung 500 untergebracht ist. Das Verfahren umfasst:
- Bereitstellen S110 einer Spannung für einen Fahrzeugcontroller 600;
- Übermitteln S120, durch den Fahrzeugcontroller 600, eines Taktsignals 50 mit einer vorbestimmten Frequenz f0;
- Teilen S130 der Frequenz f0 des Taktsignal 50 mit einem nicht-binären Teilerverhältnis; und
- Authentifizieren S140 des Fahrzeugcontrollers 600, wenn die geteilte Frequenz f in einem vorbestimmten Akzeptanzfenster liegt.

Das Verfahren kann außerdem die Schritte umfassen:
- Ändern der vorbestimmten Frequenz des Taktsignals 50 und Verifizieren einer erwarteten Änderung an dem Controllereingang 630; und/oder
- Ändern des nicht-binären Teilerverhältnisses (durch Schalten der Schalter 220) und Verifizieren einer erwarteten Änderung an dem Controllereingang 630.

Es versteht sich, dass alle zuvor beschriebenen Funktionen der Auswerteschaltung als weitere optionale Verfahrensschritte ausgebildet sein können. Außerdem versteht es sich, dass die Reihenfolge der Nennung nicht notwendigerweise eine Reihenfolge bei der Ausführung der Verfahrensschritte impliziert. Die Schritte können auch in einer anderen Reihenfolge ausgeführt werden bzw. es wird nur ein Teil der Verfahrensschritte ausgeführt.

Das Verfahren kann ebenfalls Computer-implementiert sein, d.h. es kann durch Anweisungen umgesetzt sein, die auf einem Speichermedium gespeichert sind und in der Lage sind, die Schritte des Verfahrens auszuführen, wenn es auf einem Prozessor läuft. Die Anweisungen umfassen typischerweise eine oder mehrere Anweisungen, die auf unterschiedliche Art auf unterschiedlichen Medien in oder peripher zu einer Steuereinheit (mit einem Prozessor) gespeichert sein können, die, wenn sie gelesen und durch die Steuereinheit ausgeführt werden, die Steuereinheit dazu veranlassen, Funktionen, Funktionalitäten und Operationen auszuführen, die zum Ausführen eines Verfahrens gemäß der vorliegenden Erfindung notwendig sind.

Die Beschreibung und die Zeichnungen veranschaulichen lediglich die Grundsätze der Offenbarung. Der Fachmann wird daher in der Lage sein, verschiedene Anordnungen zu entwickeln, die, obwohl sie hier nicht ausdrücklich beschrieben oder gezeigt werden, die Grundsätze der Offenbarung verkörpern und in deren Anwendungsbereich fallen.

Die Funktionen verschiedener in den Figuren dargestellter Elemente, einschließlich aller Funktionsblöcke, die als "Kopplungsschaltungen", "Verzögerungsvorrichtung", "Zähleinheiten", usw. bezeichnet werden, können durch die Verwendung spezieller Hardware, wie "Signalgeber", "Signalverarbeitungseinheit", "Prozessor", "Steuereinheit" usw., sowie durch Hardware, die in der Lage ist, Software in Verbindung mit entsprechender Software auszuführen, bereitgestellt werden. Darüber hinaus kann jede hier als "Gerät" bezeichnete Einheit "einem oder mehreren Modulen", "einem oder mehreren Geräten", "einer oder mehreren Einheiten" usw. entsprechen oder als solche implementiert sein. Wenn die Funktionen von einem Prozessor bereitgestellt werden, können sie von einem einzelnen dedizierten Prozessor, von einem einzelnen gemeinsam genutzten Prozessor oder von einer Vielzahl einzelner Prozessoren, von denen einige gemeinsam genutzt werden können, bereitgestellt werden. Darüber hinaus ist die ausdrückliche Verwendung des Begriffs "Prozessor" oder "Controller" nicht so zu verstehen, dass er sich ausschließlich auf Hardware bezieht, die in der Lage ist, Software auszuführen, und kann implizit und ohne Einschränkung digitale Signalprozessor-Hardware (DSP), Netzwerkprozessoren, anwendungsspezifische integrierte Schaltungen (ASIC), feldprogrammierbare Gate-Arrays (FPGA), Festwertspeicher (ROM) zum Speichern von Software, Arbeitsspeicher (RAM) und nichtflüchtige Speicher umfassen. Andere Hardware, konventionell und/oder kundenspezifisch, kann ebenfalls enthalten sein.

Fachleute sollten wissen, dass alle hierin enthaltenen Blockdiagramme konzeptionelle Ansichten von Schaltungen darstellen, die die Prinzipien der Offenbarung verkörpern. In ähnlicher Weise wird anerkannt, dass alle Ablaufdiagramme, Flussdiagramme, Zustandsübergangsdiagramme, Pseudocodes und dergleichen verschiedene Prozesse darstellen, die im Wesentlichen in einem computerlesbaren Medium dargestellt und so von einem Computer oder Prozessor ausgeführt werden können, unabhängig davon, ob ein solcher Computer oder Prozessor explizit dargestellt ist oder nicht.

Darüber hinaus werden die folgenden Ansprüche hiermit in die ausführliche Beschreibung aufgenommen, wobei jeder Anspruch für sich allein als ein separates Beispiel stehen kann. Während jeder Anspruch für sich allein als separates Beispiel stehen kann, ist zu beachten, dass - obwohl sich ein abhängiger Anspruch in den Ansprüchen auf eine spezifische Kombination mit einem oder mehreren anderen Ansprüchen beziehen kann - andere Beispiele auch eine Kombination des abhängigen Anspruchs mit dem Gegenstand jedes anderen abhängigen oder unabhängigen Anspruchs umfassen können. Solche Kombinationen werden hier vorgeschlagen, es sei denn, es wird angegeben, dass eine bestimmte Kombination nicht beabsichtigt ist. Darüber hinaus ist beabsichtigt, auch Merkmale eines Anspruchs in einen anderen unabhängigen Anspruch einzubeziehen, selbst wenn dieser Anspruch nicht direkt von dem unabhängigen Anspruch abhängig gemacht wird.

Es ist ferner zu beachten, dass die in der Beschreibung oder in den Ansprüchen offenbarten Verfahren durch eine Vorrichtung implementiert werden können, die Mittel zur Durchführung jeder der jeweiligen Handlungen dieser Verfahren aufweist. Ferner ist zu verstehen, dass die Offenbarung mehrerer Handlungen oder Funktionen, die in der Beschreibung oder den Ansprüchen offenbart sind, nicht so ausgelegt werden kann, dass sie in einer bestimmten Reihenfolge erfolgen. Die Offenlegung mehrerer Handlungen oder Funktionen schränkt diese daher nicht auf eine bestimmte Reihenfolge ein, es sei denn, solche Handlungen oder Funktionen sind aus technischen Gründen nicht austauschbar. Darüber hinaus kann in einigen Beispielen eine einzelne Handlung mehrere Teilhandlungen umfassen oder in mehrere Teilhandlungen unterteilt sein. Solche Unterhandlungen können in die Offenbarung dieser einzelnen Handlung einbezogen werden, sofern sie nicht ausdrücklich ausgeschlossen sind.

Darüber hinaus kann zwar jede Ausführungsform für sich alleinstehen, es ist jedoch zu beachten, dass in anderen Ausführungsformen die definierten Merkmale unterschiedlich kombiniert werden können, d. h. ein bestimmtes Merkmal, das in einer Ausführungsform beschrieben wird, kann auch in anderen Ausführungsformen realisiert werden. Solche Kombinationen sind durch die vorliegende Offenbarung abgedeckt, es sei denn, es wird angegeben, dass eine bestimmte Kombination nicht beabsichtigt ist.

### BEZUGSZEICHENLISTE

- 10: (digitaler) Frequenzteiler
- 50: Taktsignal
- 60: Grundzustand
- 100, 400: Zähleinheit(en)
- 110, 410: Takteingang
- 120, 420: Rücksetzeingang
- 130, 430: Ausgänge
- 200: erste Kopplungsschaltung
- 210: Diode(n)
- 220: (mehrere) Schalter
- 250: Koppelsignal
- 300: zweite Kopplungsschaltung
- 310: Verzögerungsschaltung
- 311,312: RC-Glied
- 313,314: Tiefpassfilter
- 320: Widerstand
- 330: Spannungsanschluss
- 450: Ausgabe, Ausgabesignal(e)
- 500: Spannungsversorgungsschaltung
- 550: Power-Management-System
- 600: Controller
- 610: Anschluss für Spannungsversorgung
- 620: Ausgabe eines Taktsignals
- 630: Controllereingang für eine Ausgabe des Frequenzteilers
- 640: zumindest einen Steuerausgang für den/die Schalter
- f0: Frequenz des Taktsignals
- Qn: Teilersignale
- GND: Masse

## Patentansprüche

1. Digitaler Frequenzteiler (10) für eine Spannungsversorgungsschaltung (500) eines Controllers (600), der digitale Frequenzteiler (10) umfasst eine Zähleinheit (100), die einen Takteingang (110) für ein Taktsignal (50), einen Rücksetzeingang (120) für ein Rücksetzsignal und einer Vielzahl von Ausgängen (130) für Teilersignale (Qn) aufweist, die Zähleinheit (100) ist ausgebildet, um die Teilersignale (Qn) als eine Teilung des Taktsignales (50) mit einer Potenz von 2 zu erzeugen,
**gekennzeichnet durch:**
- eine erste Kopplungsschaltung (200) zum Koppeln der Teilersignale (Qn) zu einem Koppelsignal (250), wobei das Koppelsignal (250) ein logisches HIGH nur aufweist, wenn alle gekoppelten Teilersignale (Qn) ein logisches HIGH aufweisen, und
- eine zweite Kopplungsschaltung (300), die ausgebildet ist, um das Koppelsignal (250) in den Rücksetzeingang (120) der Zähleinheit (100) einzugeben.

2. Digitaler Frequenzteiler (10) nach Anspruch 1, wobei die erste Kopplungsschaltung (200) für jedes Teilersignal (Qn) einen Eingang mit jeweils einer Diode (210) aufweist, wobei die Dioden (210) angeordnet sind, um einen Signalfluss in die Zähleinheit (100) zu unterdrücken und um die Teilersignale (Qn) von der Zähleinheit (100) an einem Ausgang der ersten Kopplungsschaltung (200) zu dem Koppelsignal (250) zu überlagern.

3. Digitaler Frequenzteiler (10) nach Anspruch 2, wobei die erste Kopplungsschaltung (200) zumindest einen Schalter (220) zwischen einer jeweiligen Diode (210) und dem jeweiligen Eingang der ersten Kopplungsschaltung (200) aufweist, um ansprechend auf ein Steuersignal die jeweilige Diode (210) zu entkoppeln und so ein Kopplungssignal (250) mit einem anderen Teilerverhältnis zu erzeugen.

4. Digitaler Frequenzteiler (10) nach einem der vorhergehenden Ansprüche, wobei die zweite Kopplungsschaltung (300) eine Verzögerungsschaltung (310) aufweist, die ausgebildet ist, um das Koppelsignal (250) von der ersten Kopplungsschaltung (200) zeitlich verzögert in den Rücksetzeingang (120) der Zähleinheit (100) einzugeben.

5. Digitaler Frequenzteiler (10) nach einem der vorhergehenden Ansprüche, wobei die zweite Kopplungsschaltung (300) einen Widerstand (320) und einen Anschluss (330) an eine Versorgungsspannung aufweist.

6. Digitaler Frequenzteiler (10) nach einem der vorhergehenden Ansprüche, der weiter Folgendes aufweist:
eine weitere Zähleinheit (400), die einen Takteingang (410) für ein Taktsignal, einen Rücksetzeingang (420) für ein Rücksetzsignal und eine Vielzahl von Ausgängen (430) für weitere Teilersignale aufweist,
wobei die zweite Kopplungsschaltung (300) ausgebildet ist, um das Koppelsignal (250) in den Takteingang (410) der weiteren Zähleinheit (400) einzugeben und der Rücksetzeingang (420) der weiteren Zähleinheit (400) mit einem Masseanschluss (GND) verbunden ist, und die Vielzahl von Ausgängen (430) der weiteren Zähleinheit (400) Ausgabesignale (450) für die Spannungsversorgungsschaltung (500) und/oder für den Controller (600) bereitstellen.

7. Spannungsversorgungsschaltung (500) für einen Controller (600) eines Fahrzeuges, die Spannungsversorgungsschaltung (500) umfasst:
- Power-Management-System (550) zur Bereitstellung einer Spannung für den Controller (600); und
- einen digitalen Frequenzteiler (10) nach einem der vorhergehenden Ansprüche, der ausgebildet ist, um ein Taktsignal (50) von dem Controller (600) zu empfangen und das empfangene Taktsignal (50) in einem vorbestimmten Teilerverhältnis zu teilen und eine Ausgabe (450) an das Power-Management-System (550) zu liefern.

8. Spannungsversorgungsschaltung (500) nach Anspruch 7, wobei das Power-Management-System (550) ausgebildet ist, um den Controller (600) basierend auf der Ausgabe (450) zu authentifizieren, wenn die Ausgabe (450) eine Frequenz aufweist, die in einem vorbestimmten Akzeptanzfensters liegt.

9. Spannungsversorgungsschaltung (500) nach Anspruch 7 oder Anspruch 8, wobei das Taktsignal eine Frequenz, f0, zwischen 10 KHz und 100 KHz oder ungefähr 25 KHz oder ungefähr 28 kHz aufweist und das vorbestimmte Teilerverhältnis 1:n ist, wobei n eine ganze Zahl zwischen 16 und 32 ist.

10. Controller (600) eines Fahrzeugs, der Folgendes aufweist:
einen Anschluss (610) für eine Spannungsversorgungschaltung (500) nach einem der Ansprüche 7 bis 9,
eine Ausgabe (620) für ein Taktsignal (50) mit vorbestimmter Frequenz, f0, für einen digitalen Frequenzteiler (10) nach einem der Ansprüche 1 bis 6;
wobei der Controller (600) ausgebildet ist, um den digitalen Frequenzteiler (10) zu steuern.

11. Controller (600) nach Anspruch 10, der einen Controllereingang (630) für eine Ausgabe des einen digitalen Frequenzteiler (10) und zumindest einen Steuerausgang (640) zum Ansteuern des zumindest einen Schalters (220) nach Anspruch 3 aufweist,
wobei der Controller (600) ausgebildet ist, um einen Testmodus auszulösen, in dem der Controller (600) zumindest eines aus dem Folgenden bewirkt:
- Ändern der vorbestimmten Frequenz, f0, des Taktsignals (50) und Verifikation einer erwarteten Änderung am Controllereingang (630);
- wahlweises Entkoppeln einer oder mehrerer Dioden (210) durch ein Betätigen der entsprechenden Schalter (220) nach Anspruch 3 und Verifikation einer erwarteten Änderung am Controllereingang (630).

12. Nutzfahrzeug, insbesondere ein Lastkraftwagen oder Bus, mit
- einem Controller (600) nach Anspruch 10 oder Anspruch 11; und
- einer Spannungsversorgungsversorgungsschaltung (500) nach einem der Ansprüche 7 bis 9.

13. Verfahren zum Betreiben und Testen einer Spannungsversorgungsschaltung (500) nach einem der Ansprüche 7 bis 9, mit folgenden Schritten:
- Bereitstellen (S110) einer Spannung für einen Fahrzeugcontroller (600);
- Übermitteln (S120), durch den Fahrzeugcontroller (600), eines Taktsignals (50) mit einer vorbestimmten Frequenz f0;
- Teilen (S130) der Frequenz f0 des Taktsignal (50) mit einem nicht-binären Teilerverhältnis; und
- Authentifizieren (S140) des Fahrzeugcontrollers (600), wenn die geteilte Frequenz in einem vorbestimmten Akzeptanzfenster liegt.

14. Verfahren nach Anspruch 13, das ein Weiterleiten einer geteilten Frequenz f an einen Controllereingang (630) des Fahrzeugcontrollers (600) umfasst und das Verfahren weiter ein Testen der Spannungsversorgungsschaltung (500) umfasst, wobei das Testen zumindest einen der folgenden Schritte umfasst:
- Ändern der vorbestimmten Frequenz f0 des Taktsignals (50) und Verifizieren einer erwarteten Änderung an dem Controllereingang (630);
- Ändern des nicht-binären Teilerverhältnisses und Verifizieren einer erwarteten Änderung an dem Controllereingang (630).

15. Computerlesbares Speichermedium mit darauf gespeicherten Anweisungen, die ausgebildet sind, um die Spannungsversorgungschaltung (500) nach Anspruch 7 und den Controller nach Anspruch 10 zu veranlassen, das Verfahren nach Anspruch 12 auszuführen, wenn die Anweisungen auf einer Datenverarbeitungseinheit ausgeführt werden.
